# EUROPEAN PATENT APPLICATION

(11) **EP 4 733 703 A1**
(43) Date of publication of application: **29.04.2026**
(21) Application number: 25153788.2
(22) Date of filing: 24.01.2025
(51) Int. Cl.: F28F 3/04, H01F 27/10

(54) **CORRUGATED HEAT DISSIPATING ELEMENT FOR RADIATOR**

(30) Priority: 28.10.2024 IN 202441082439
(71) Applicant: TTP Technologies Private Limited, Bangalore 560058 (IN)
(72) Inventor: SHETTY, Mohandas D, 560052 Bangalore (IN)
(74) Representative: Mathys & Squire

(57) **Abstract**

A corrugated heat dissipating element for a radiator for better thermal performance by dissipating more heat from high viscous oil filled transformer. The heat dissipating element includes a body with a top, middle, and bottom portion, incorporating multiple flutes that create continuous channels for fluid flow. The heat dissipating element comprises a plurality of flutes defined in a body thereof, with a transverse section of each flute representing two trapezium mirrored to each other along a base. Each flute has a hexagonal cross-section created by two mirrored trapeziums, which have a corrugated profile that optimizes fluid dynamics and enhances heat dissipation. This profile, characterized by alternating crests and troughs, forms a wave-like surface pattern, with a major axis between the crests and a minor axis between the troughs, maximizing both heat transfer efficiency and fluid flow dynamics.

## Description

### FIELD OF THE PRESENT DISCLOSURE

The present disclosure, generally, relates to a radiator for cooling a transformer, and particularly to a corrugated heat dissipating element of a radiator to optimize fluid flow distribution and enhance heat dissipation.

### BACKGROUND

The basic objective in any structural design is to provide a structure capable of resisting all the loads without failure during the intended life. Power transformers designed to distribute large amounts of power, such as substation and distribution class power transformers, may suffer due to overheat. For instance, if the cooling is compromised, the transformer temperature may rise above desired values. Such a rise in temperature may result in the outright failure of the power transformer and at a minimum will result in some damage and an accelerated loss of life. That is, over time excessive heating will reduce transformer life and lead to premature failure which will affect the ability of a utility company to supply uninterrupted supply of power to its customers and will cost the operating utility significant replacement costs.

Transformers generally include cooling systems to remove heat generated when large loads are applied to the transformers (i.e., when large currents are drawn from and through the transformer). Maintaining the transformer temperature below a critical value enables the transformer to handle a designated power capacity or to increase the power handling capability of the transformer. The cooling systems are designed to remove heat to help keep the transformer and its components below predetermined critical temperatures. Generally, the cooling system has the transformer contained within a liquid (e.g., oil) filled tank with or without oil pumps being used to circulate the fluid through radiators attached to the tank. The operation of the radiator is vital for the transformer to deliver its designated power capacity.

There are different design implementations of the radiator known in the art. The most common and widely used radiators include tubular type radiators. In a tubular-type radiator, an upper side which receives the heated oil from the transformer and a lower side which supplies back the oil to the transformer are connected by a series of tubes through which the oil passes. Air passes around the outside of the tubes, absorbing heat from the oil (or water) in passing. In some examples, fins are placed around the tubes to improve heat transfer. In such tubular-type radiators, tubes are welded to the top and lower sides which may lead to structural integrity concerns. The tubes being straight are generally disposed close to heat dissipating portion of the transformer and thus may have less exposure to cool air from the atmosphere. Thus, large capacity transformer requires the radiator to have a larger number of tubes, and further tubes of larger length, to achieve required thermal performance. Thus, the tubular-type radiators are not economical in practice for power transformer applications.

Existing solutions often involve simple flat or finned heat exchangers that lack sufficient surface area and optimized fluid dynamics to dissipate heat efficiently. These designs may also lead to uneven fluid flow distribution, further hindering thermal performance.

Moreover, the transformer industry is increasingly switching over to environmental-friendly ester-based oil for transformers from mineral-based oil. Ester-based oil has come into the market with its major advantage of being bio-degradable. But one of the major limitations of the ester-based oil is its high viscosity. In actual scenario for high viscous oil, if the hydraulic dimensions of the tubes in the radiator are small, the frictional forces are more. If the hydraulic dimensions are large, radiator's manufacturers endure from manufacturing process limitation and transformers will endure from excess oil consumption. This becomes a major setback in the thermal performance of the tubular-type radiators.

The present disclosure has been made in view of such considerations, and it is an object of the present disclosure to provide a heat dissipating element for a radiator which overcomes the problems associated with the known designs, including structural concerns, and provide better cooling performance for the radiator.

### SUMMARY

The present disclosure introduces a corrugated heat dissipating element for radiators, specifically designed to enhance heat transfer by maximizing surface area and optimizing fluid flow. The unique hexagonal flute design, combined with a corrugated profile, improves fluid circulation, promotes effective heat dissipation, and increases the efficiency of cooling systems in oil-filled transformers.

In an aspect, a corrugated heat dissipating element for a radiator is disclosed. The corrugated heat dissipating element comprises a body having a top portion, a bottom portion and a middle portion. The corrugated heat dissipating element further comprises a plurality of flutes defined in the body. Each of the plurality of flutes provides a continuous channel to allow for flow of a fluid therein. The corrugated heat dissipating element also comprises an inlet port provided at the top portion to receive the fluid and supply the fluid to each of the plurality of flutes, and an outlet port provided at the bottom portion to collect the fluid from each of the plurality of flutes. In the corrugated heat dissipating element, one or more of the plurality of flutes are extending longitudinally downwards and diverging laterally outwards from the inlet port in the top portion of the body, extending longitudinally downwards in the middle portion of the body, and extending longitudinally downwards and converging laterally inwards towards the outlet port in the bottom portion of the body. In the corrugated heat dissipating element, a cross-section of each one of the flutes has a hexagonal profile, formed of two trapeziums mirrored to each other along bases thereof. Each of the mirrored trapeziums of the plurality of the flutes includes a corrugated profile to optimize fluid flow distribution and enhance heat dissipation. The corrugated profile comprises alternating crests and troughs, forming a wave-like pattern along the surface of the mirrored trapeziums, such that a major axis is formed between the crests of the mirrored trapeziums and a minor axis is formed between the troughs of the mirrored trapeziums.

In one or more embodiments, the plurality of flutes comprises nine number of flutes.

In one or more embodiments, a sheet surface of the body comprising the plurality of flutes is configured in a trapezoidal shape.

In one or more embodiments, the fluid comprises high viscous dielectric oil including ester oil.

In one or more embodiments, a longitudinal length of each of the one or more heat dissipating elements is in a range of 500 mm up to 4500 mm.

In one or more embodiments, the heat dissipating element comprises a first metal sheet formed to define a plurality of first open corrugated profiles extending along a longitudinal length thereof. The heat dissipating element further comprises a second metal sheet formed to define a plurality of second open corrugated profiles extending along a longitudinal length thereof, the second corrugated profiles being complementary to the plurality of predefined open corrugated profiles formed in the first metal sheet. The first metal sheet and the second metal sheet are joined so as to form the body having the top portion, the bottom portion and the middle portion, with the plurality of flutes defined therein by the closed configuration of the first open corrugated profiles and the second open corrugated profiles, wherein each of the plurality of flutes forming an optimized continuous channel configured to allow fluid flow therethrough, thereby reducing oil consumption and enhancing heat dissipation.

In another aspect, a radiator for cooling a device is disclosed. Herein, the device has a fluid flowing therethrough to extract heat therefrom. The radiator comprises a first collector pipe disposed in connection with the device to be cooled to receive the fluid therefrom. The radiator also comprises a second collector pipe disposed in connection with the device to be cooled to supply back the fluid thereto. The radiator further comprises one or more heat dissipating elements. Each of the one or more heat dissipating elements comprises a body having a top portion, a bottom portion and a middle portion; a plurality of flutes defined in the body, with each of the plurality of flutes providing a continuous channel to allow for flow of the fluid therein; an inlet port provided at the top portion in fluid communication with the first collector pipe to receive the fluid therefrom, and to supply the fluid to each of the plurality of flutes; and an outlet port provided at the bottom portion to collect the fluid from each of the plurality of flutes, and in fluid communication with the second collector pipe to supply the collected fluid thereto. In the heat dissipating element, one or more of the plurality of flutes are extending longitudinally downwards and diverging laterally outwards from the inlet port in the top portion of the body, extending longitudinally downwards in the middle portion of the body, and extending longitudinally downwards and converging laterally inwards towards the outlet port in the bottom portion of the body. In the corrugated heat dissipating element, a cross-section of each one of the flutes has a hexagonal profile, formed of two trapeziums mirrored to each other along bases thereof. Each of the mirrored trapeziums of the plurality of the flutes includes a corrugated profile to optimize fluid flow distribution and enhance heat dissipation. The corrugated profile comprises alternating crests and troughs, forming a wave-like pattern along the surface of the mirrored trapeziums, such that a major axis is formed between the crests of the mirrored trapeziums and a minor axis is formed between the troughs of the mirrored trapeziums.

In one or more embodiments, a longitudinal length of each of the one or more heat dissipating elements is in a range of 500 mm up to 4500 mm.

In one or more embodiments, a number of the one or more heat dissipating elements varies from 1 to 45.

In one or more embodiments, a sheet surface of the body comprising the plurality of flutes is configured in a trapezoidal shape.

In one or more embodiments, the fluid comprises high viscous dielectric oil including ester oil.

The foregoing summary is illustrative only and is not intended to be in any way limiting. In addition to the illustrative aspects, embodiments, and features described above, further aspects, embodiments, and features will become apparent by reference to the drawings and the following detailed description.

### BRIEF DESCRIPTION OF THE FIGURES

For a more complete understanding of example embodiments of the present disclosure, reference is now made to the following descriptions taken in connection with the accompanying drawings in which:
FIG. 1A illustrates a diagrammatic cross-section view of the corrugated heat dissipating element of the radiator, in accordance with one or more exemplary embodiments of the present disclosure;
FIG. 1B illustrates a diagrammatic cross-section view of a single flute of the corrugated heat dissipating element of the radiator, in accordance with one or more exemplary embodiments of the present disclosure;
FIG. 2A illustrates a diagrammatic front planar view of the corrugated heat dissipating element of the radiator, in accordance with one or more exemplary embodiments of the present disclosure;
FIG. 2B illustrates a diagrammatic left side planar view of the corrugated heat dissipating element of the radiator, in accordance with one or more exemplary embodiments of the present disclosure;
FIG. 2C illustrates a diagrammatic rear planar view of the corrugated heat dissipating element of the radiator, in accordance with one or more exemplary embodiments of the present disclosure;
FIG. 2D illustrates a diagrammatic right side planar view of the corrugated heat dissipating element of the radiator, in accordance with one or more exemplary embodiments of the present disclosure;
FIG. 3A illustrates a diagrammatic perspective view of the radiator, in accordance with one or more exemplary embodiments of the present disclosure;
FIG. 3B illustrates a diagrammatic side planar view of the radiator, in accordance with one or more exemplary embodiments of the present disclosure;
FIG. 4A illustrates a diagrammatic top planar view of the radiator, in accordance with one or more exemplary embodiments of the present disclosure;
FIG. 4B illustrates a diagrammatic top planar view of the corrugated heat dissipating element of the radiator, in accordance with one or more exemplary embodiments of the present disclosure;
FIG. 5A (Prior Art) illustrates a diagrammatic cross-section view of a standard plain flute configuration of a heat dissipation element in a radiator;
FIG. 5B (Prior Art) illustrates a diagrammatic cross-section view of a single flute of the heat dissipating element of the radiator;
FIG. 6 illustrates a diagrammatic perspective view of a transformer device utilizing multiple radiators, in accordance with one or more exemplary embodiments of the present disclosure;
FIG. 7 illustrates an exemplary graph indicative of temperature rise of oil with time in the radiator, in accordance with one or more exemplary embodiments of the present disclosure; and
FIG. 8 illustrates an exemplary graph indicative of rate of heat dissipation from the heat dissipating element of the radiator across lateral length thereof for different ambient temperature conditions, in accordance with one or more exemplary embodiments of the present disclosure.

### DETAILED DESCRIPTION

In the following description, for purposes of explanation, numerous specific details are set forth in order to provide a thorough understanding of the present disclosure. It will be apparent, however, to one skilled in the art that the present disclosure is not limited to these specific details.

Reference in this specification to "one embodiment" or "an embodiment" means that a particular feature, structure, or characteristic described in connection with the embodiment is included in at least one embodiment of the present disclosure. The appearance of the phrase "in one embodiment" in various places in the specification are not necessarily all referring to the same embodiment, nor are separate or alternative embodiments mutually exclusive of other embodiments. Further, the terms "a" and "an" herein do not denote a limitation of quantity, but rather denote the presence of at least one of the referenced items. Moreover, various features are described which may be exhibited by some embodiments and not by others. Similarly, various requirements are described which may be requirements for some embodiments but not for other embodiments.

Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

Some portions of the detailed description that follows are presented and discussed in terms of a process or method. Although steps and sequencing thereof are disclosed in figures herein describing the operations of this method, such steps and sequencing are exemplary. Embodiments are well suited to performing various other steps or variations of the steps recited in the flowchart of the figure herein, and in a sequence other than that depicted and described herein.

The present disclosure, generally, relates to a radiator for cooling a transformer, and particularly to a corrugated heat dissipating element of a radiator to optimize fluid flow distribution and enhance heat dissipation. In a transformer, a radiator is a cooling component used to dissipate the heat generated during operation. Transformers heat up due to electrical losses, mainly from the core and windings, and this heat needs to be managed to prevent damage or reduced efficiency. The radiator, usually made up of a series of metal fins or tubes, helps cool the transformer oil (in oil-cooled transformers). The heated oil flows through the radiator, where it cools down by transferring heat to the surrounding air, thus maintaining an optimal temperature for the transformer's performance and longevity.

In the transformer device, the power transformer is cooled by immersing it in a fluid (e.g., oil, with the two terms being interchangeably used). For this purpose, the housing is filled with the oil to extract heat from the power transformer. Now, this fluid needs to be transferred out of the housing to be cooled and to be re-circulated back into the housing to again be used for heat extraction from the power transformer. The transformer device includes one or more radiators for the said purpose. The radiators are heat exchangers used to transfer thermal energy from one medium to another for the purpose of cooling and/or heating, such as, in the present case, from the oil to the atmosphere. The radiators usually provide a large amount of cooling surface to be in contact with large amounts of air so that it spreads through the oil to cool efficiently. The transformer and radiators will be explained later.

The present disclosure introduces a corrugated heat dissipating element for radiators, specifically designed to enhance heat transfer by maximizing surface area and optimizing fluid flow. The unique hexagonal flute design, combined with a corrugated profile, improves fluid circulation, promotes effective heat dissipation, and increases the efficiency of cooling systems in oil-filled transformers.

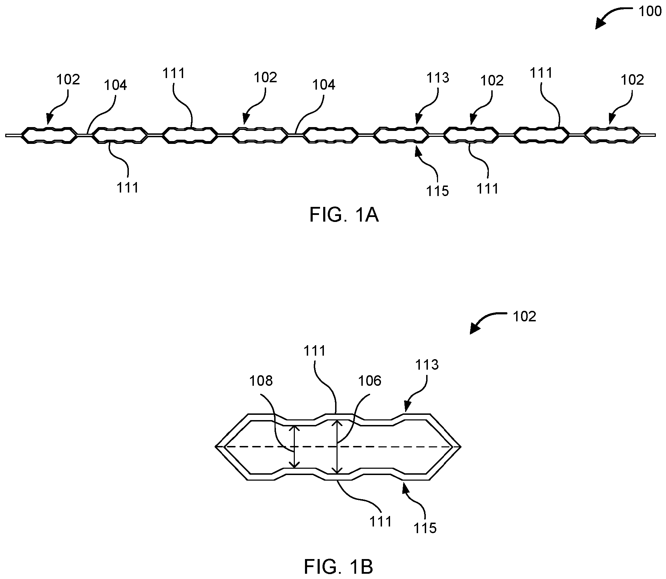

FIG. 1A illustrates a cross-section view of the heat dissipating element 100 showing in detail the individual flutes 102 therein. In the present exemplary embodiment, the heat dissipating element 100 includes nine number of flutes 102. Hereinafter, the terms "heat dissipating element" and "corrugated heat dissipating element" are used interchangeably without any limitations. That is, the plurality of flutes 102 includes nine number of flutes 102. It may be appreciated that the said number of flutes 102 is a preferred embodiment, and is not limiting the present disclosure. As shown, a cross-section of each one of the plurality of flutes 102 is in the form of two trapeziums mirrored to each other along bases thereof. In the heat dissipating element 100, each mirrored trapezium of the plurality of flutes 102 includes a corrugated profile to optimize fluid flow distribution and enhance heat dissipation. In one or more embodiments, in the heat dissipating element 100, each mirrored trapezium of the nine number of flutes 102 includes a corrugated profile to optimize fluid flow distribution and enhance heat dissipation. Hereinafter, the terms "plurality of flutes" or "9-flute corrugated profile" or "9-flute profile" or "flutes" are used interchangeably without any limitations.

FIG. 1B illustrates a detailed section view of the individual flute 102. It may be seen that the flute 102 has a hexagonal profile, particularly formed of two trapeziums mirrored to each other along bases (as represented by dashed line) thereof. As shown, the corrugated profile comprises alternating crests and troughs, forming a wave-like pattern along the surface 111 of the mirrored trapeziums. Further, as shown, the corrugated profile comprises alternating crests and troughs, forming a wave-like pattern along the surface 111 of the mirrored trapeziums, such that a major axis 106 is formed between the crests of the mirrored trapeziums, while a minor axis 108 is formed between the troughs of the mirrored trapeziums.

The heat dissipating element incudes a first metal sheet 113 formed to define a plurality of first open corrugated profiles extending along a longitudinal length thereof. The heat dissipating element further incudes a second metal sheet 115 formed to define a plurality of second open corrugated profiles extending along a longitudinal length thereof, the second corrugated profiles being complementary to the plurality of predefined open corrugated profiles formed in the first metal sheet 113. The first metal sheet 113 and the second metal sheet 115 are joined so as to form the body having the top portion, the bottom portion and the middle portion, with the plurality of flutes defined therein by the closed configuration of the first open corrugated profiles and the second open corrugated profiles, wherein each of the plurality of flutes forming an optimized continuous channel configured to allow fluid flow therethrough, thereby reducing oil consumption and enhancing heat dissipation.

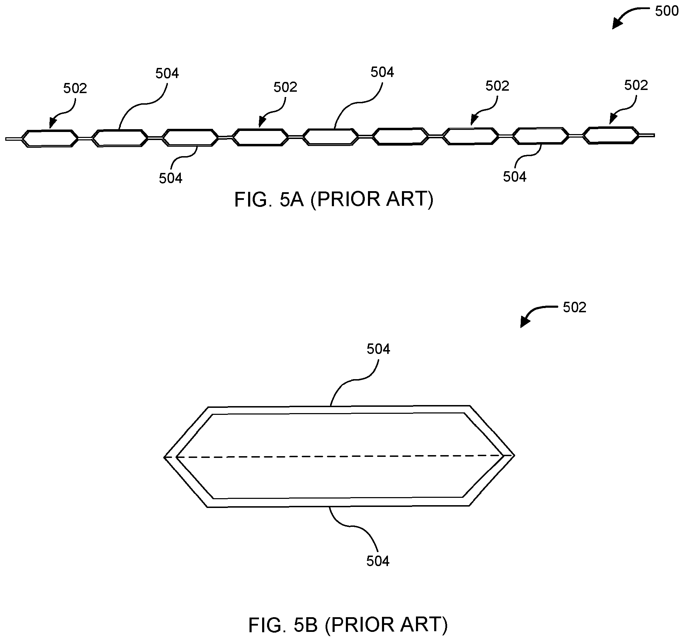

The corrugated profiles, which are essentially wavy or ridged patterns formed on both the first metal sheet 113 and the second metal sheet 115, serve to increase the overall surface area of the heat dissipating element. When the first metal sheet 113 and the second metal sheet 115 are joined, their complementary corrugated profiles interlock, forming a series of flutes-elongated, tube-like structures. These flutes are created from the corrugations and form channels for fluid to flow through. Due to the wavy nature of the corrugations, the surface area of each flute is significantly greater than it would be if the flutes were flat or plain as shown in FIGS. 5A (Prior Art) and 5B (Prior Art). The increased surface area is essential because the heat dissipation largely depends on how much of the surface is exposed to cool air from the atmosphere. With more surface area, more heat can be transferred from the heat dissipating element to the surrounding environment. This maximizes the efficiency of heat removal, allowing the element to cool faster and more effectively.

The corrugations form structured channels within the flutes when the two metal sheets are combined. These channels are not uniform or linear; instead, they are shaped by the interlocking corrugations, which create a more complex flow path for the oil or fluid inside. By optimizing the shape and structure of these channels, the corrugations help to regulate and manage the flow of oil. The oil can more effectively contact the interior surface of the flutes, ensuring maximum exposure to the surface area for heat exchange, without requiring a large volume of oil to do so. This optimized channel structure means that less oil is needed to achieve the same or even greater cooling efficiency, as the corrugated profile increases the interaction between the oil and the metal surface. The corrugations help ensure that the oil flows in a more controlled manner. Thus, the corrugated profiles formed on the first metal sheet 113 and the second metal sheet 115 provide a dual benefit. By increasing the surface area within the flutes, heat dissipation is significantly enhanced. At the same time, the optimized channels formed by these profiles allow for more efficient oil flow, reducing the volume of oil required while maintaining or even improving cooling performance. These combined effects make the heat dissipating element both highly efficient in its function and cost-effective by reducing resource consumption. Such profile may help with better flow of the fluid inside the flute 102, thus improving the thermal performance of the heat dissipating element 100, and thereby the overall radiator. Specifically, the 9-flute corrugated heat dissipating element 100 increases thermal efficiency by approximately 3% and reduces oil volume by about 10% compared to the standard plain flute configuration. In general, the better cooling efficiency is achieved with optimum oil channel spacing due to the distribution and the diverging-converging profiles of the flutes 102, allowing the high viscous oil, such as ester oil (with viscosity about 3.5-5 times more than mineral oil), to flow smoothly. Thus, even the transformer device with large rating/capacity, requiring a large amount of heat dissipation, may be cooled using the radiators of the present disclosure.

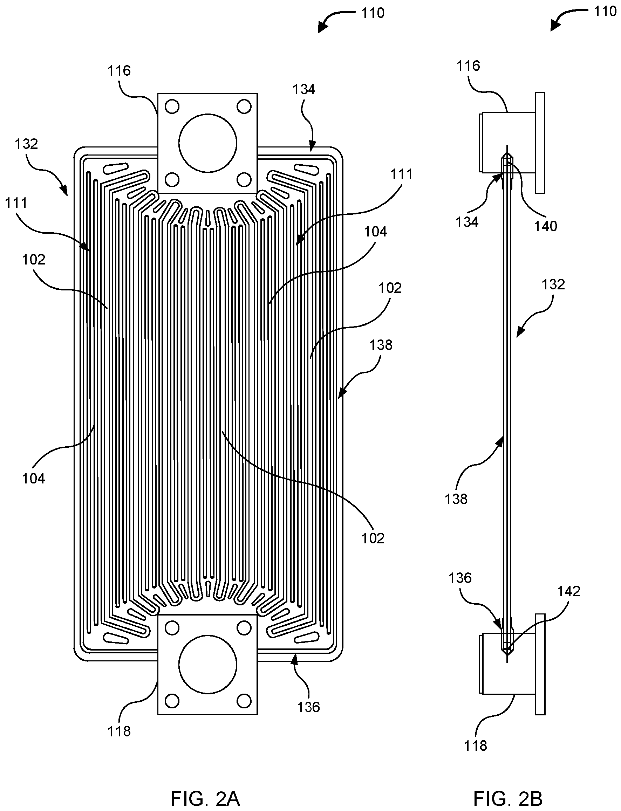

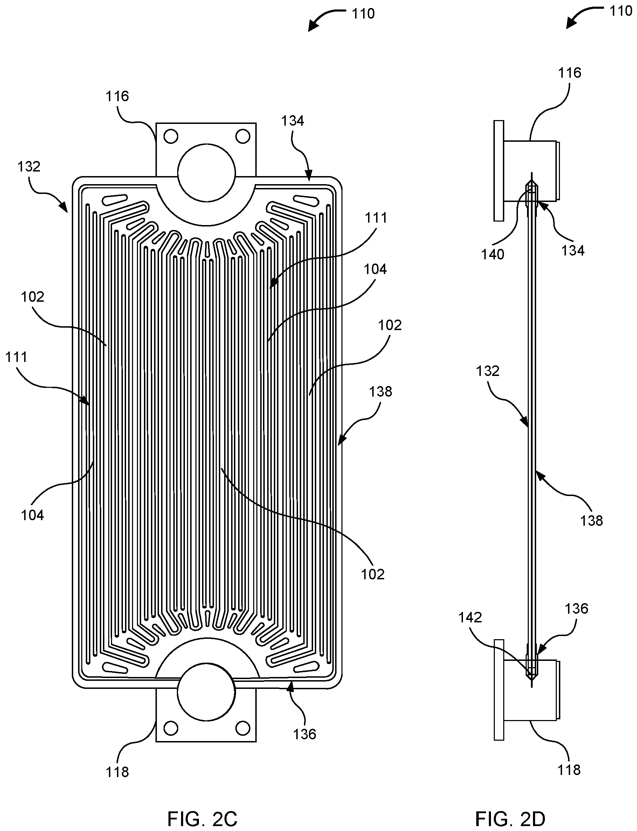

Referring now to FIGS. 2A-2D in combination, different views of one of the heat dissipating elements 100 are illustrated. In the illustrations of FIGS. 2A-2D, the heat dissipating element 100 is shown to be disposed between a first collector pipe 116 and a second collector pipe 118. The heat dissipating element 100 provides a body 132 having a top portion 134, a bottom portion 136 and a middle portion 138. The body 132 is extending between the first collector pipe 116 and the second collector pipe 118, with the top portion 134 being disposed within the first collector pipe 116 and the bottom portion 136 disposed within the second collector pipe 118, and the middle portion 138 being exposed to the atmosphere. Also, as shown, the heat dissipating element 100 includes an inlet port (generally marked by reference numeral 140) in fluid communication with the first collector pipe 116 to receive the fluid therefrom. Further, the heat dissipating element 100 includes an outlet port (generally marked by reference numeral 142) in fluid communication with the second collector pipe 118 to supply the collected fluid thereto.

Further, as shown, the heat dissipating element 100 includes a plurality of flutes 102 defined in the body 132. The flutes 102 have a corrugated profile to optimize fluid flow distribution and enhance heat dissipation. The corrugated profile comprises alternating crests and troughs, forming a wave-like pattern along the surface 111 of the mirrored trapeziums as shown in FIGS. 1A and 1B. Since the surface 111 of the mirrored trapeziums has the corrugated profile, this configuration may further enhance the heat transfer from the body 132, thereby improving the overall thermal performance of the heat dissipating element 100. Herein, the flutes 102 are in the form of channels defined in the body 132, extending from the top portion 134 to the bottom portion 136 thereof. Each of the plurality of flutes 102 provides a continuous channel to allow for flow of the fluid therein. As discussed, the inlet port 140 in the heat dissipating element 100 is provided at the top portion 134 thereof and is in fluid communication with the first collector pipe 116 to receive the fluid therefrom. Herein, the received fluid from the first collector pipe 116 via the inlet port 140 is passed to the flow inside the flutes 102 in the heat dissipating element 100. The received fluid flows in each of the flutes 102 in the heat dissipating element 100, from the top portion 134, passing through the middle portion 138 and then to the bottom portion 136 in the body 132. Further, as discussed, the outlet port 142 in the heat dissipating element 100 is provided at the bottom portion 136 thereof and is in fluid communication with the second collector pipe 118 to supply the collected fluid thereto. Specifically, in the heat dissipation element 100, the fluid flows through the major axis 106 and the minor axis 108 of the mirrored trapeziums of the flutes 102, which helps improve the flow of the oil therein as well the heat dissipation. Herein, the fluid coming from the top portion 134 and the middle portion 138 to the bottom portion 136 in the body 132 is passed via the outlet port 142 of the heat dissipating element 100 to the second collector pipe 118.

Now, as shown, the plurality of flutes 102 are extending across a longitudinal length of the body 132 in the heat dissipating element 100. Further, the plurality of flutes 102 are distributed across a lateral length of the body 132 in the heat dissipating element 100. In an example, the plurality of flutes 102 may be distributed equidistant to each other across the lateral length of the body 132; however other suitable distribution arrangement(s) may also be implemented without departing from the spirit and the scope of the present disclosure. According to embodiments of the present disclosure, one or more of the plurality of flutes 102 are extending longitudinally downwards and diverging laterally outwards from the inlet port 140 in the top portion 134 of the body 132, extending longitudinally downwards in the middle portion 138 of the body 132, and extending longitudinally downwards and converging laterally inwards towards the outlet port 142 in the bottom portion 136 of the body 132. That is, generally, each flute 102 has a diverging-converging profile, with the flutes 102 towards one of the longitudinal side (edge) from a longitudinal axis along a lateral centre of the body 132 being mirror-image to the flutes 102 towards other of the longitudinal side (edge) from the said longitudinal axis of the body 132.

Such diverging-converging profiles of the corrugated flutes 102 help to divert the oil flowing therein away from the first collector pipe 116 and the lateral centre of the body 132, and towards the flutes 102 at the lateral sides of the body 132, in the heat dissipating element 100. In other words, the diverging and converging profile of the heat dissipating element 100 allows at least some of the received oil from the first collector pipe 116 to diverge to the flutes 101 towards the lateral sides of the body 132. As may be contemplated, the surrounding temperature near middle (lateral centre) of the body 132 would be more compared to the lateral sides of the body 132, in the heat dissipating element 100. Thus, the flutes 102 towards the lateral sides of the body 132 get higher free flow of fresh air. This allows the oil present in such flutes 102 towards the lateral sides of the body 132 to cool the oil therein more quickly because of more contact with the atmospheric air. This creates a thermographic profile of parabolic in shape for the heat dissipating element 100 (as discussed later in detail).

The diverging-converging profiles of the flutes 102 may provide higher hydraulic dimensions for the flutes 102, thus helping with better flow of the oil therein. As used herein, the "hydraulic dimension" refers to characteristic length used to calculate the dimensionless number to determine if the flow is laminar or turbulent. In general, the hydraulic dimension represents an effective cross-sectional area of the flute 102 which contributes for the oil to flow through. Thereby, the heat dissipating element 100 enables for flow of high-viscosity fluid therein, which may not be possible with traditional designs. In the present embodiments, the fluid used in the transformer device to be cooled by the heat dissipating elements 100 of the radiator comprises ester oil (as discussed later in detail). The ester oil is highly viscous oil, but it may help with better heat dissipation and it is also bio-degradable. This is in contrast to mineral oils which are used in traditional set-ups because of their limitations to handle high-viscosity fluids, and which are also non-biodegradable thus posing harm to the environment when disposed. It may also be appreciated that the diverging profiles of the flutes 102 at the top portion 134 may also help to distribute the oil as received more uniformly between the multiple flutes 102 as compared to, say, traditional tubular design in which the oil is distributed from a top tank and usually the channels towards the centre may receive more flow of oil as compared to the channels towards the lateral sides, which is undesirable.

As may be seen, the body 132 of the heat dissipating element 100 is made of sheet materials with the flutes 102 defined therein (as discussed later in more detail). Thus, the body 132 of the heat dissipating element 100 provides a significantly larger surface area as compared to, say, traditional tubular design which has individual distant tubes therein. Thus, in the present heat dissipating element 100, the body 132 may also contribute towards dissipation of heat from the oil flowing in the flutes 102 to the atmospheric air. In fact, the larger surface area of the body 132 may allow to provide significantly more heat transfer, thus contributing to the thermal performance of the heat dissipating element 100. Also, in the present embodiments, the body 132 of each heat dissipating element 100 is made of steel (as discussed later in more detail). Therefore, it may be possible to have as much as up to 50 heat dissipating elements 100 in the single radiator 110 with the present design, which is not possible with traditional designs. Further, in an embodiment, a sheet surface (as marked by reference numeral 104) between the plurality of flutes 102, i.e., the area between the flutes 102 of the body 132, is corrugated. Specifically, the sheet surface 104 of the body 132 comprising the plurality of flutes 102 is configured in a trapezoidal shape. As may be understood by a person skilled in the art, such corrugated profile with trapezoidal shape of the sheet surface 104 may further enhance the heat transfer from the body 132, improving overall thermal performance of the heat dissipating element 100.

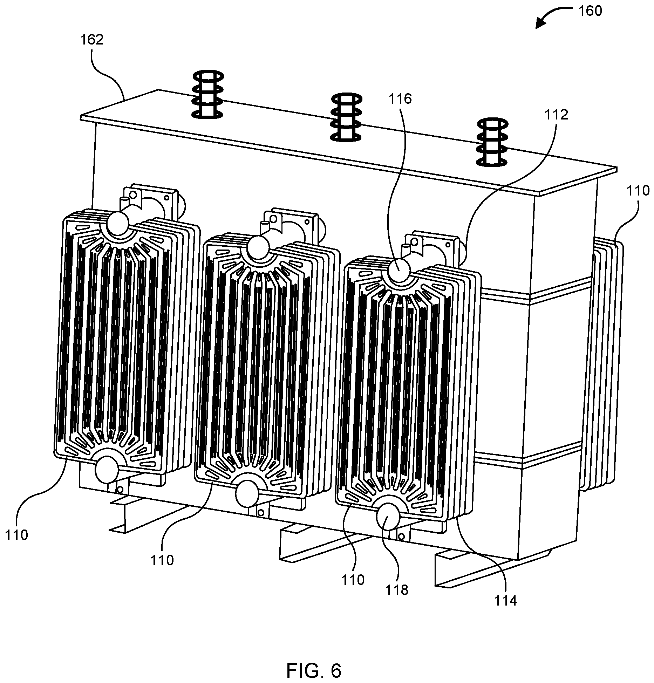

Referring to FIG. 6, illustrated is a diagrammatic perspective view of a device (represented by reference numeral 160) which needs to be cooled. In the illustrated embodiment of FIG. 6, the device 160 is a transformer device, with the two terms being interchangeably used hereinafter for the purposes of the present disclosure. However, it may be appreciated that the device 160 may be an automobile, a generator, or any similar device which may also need to be cooled (using radiator, as described in preceding paragraphs) without any limitations. As shown, the transformer device 160 includes a housing (as represented by reference numeral 162) which may enclose the actual power transformer (not visible). As is known in the art, the primary and secondary windings of the power transformer have some resistance. As current flows through the windings, heat is generated which is a function of the winding resistance multiplied by the square of the current. A considerable amount of heat may be generated by, and within, the power transformer, particularly when the load is increased and more current flows through the power transformer's primary and secondary windings.

The heat generated within the power transformer causes a rise in the temperature of the windings and in the space surrounding the windings and all around the power transformer. When the temperature rises above a certain level many problems are created. For example, the resistance of the (copper) transformer windings increases as a function of the temperature rise. The resistance increase causes a further increase in the heat being dissipated, for the same value of load current, and further decreases the efficiency of the transformer. With increased temperature, the power transformer may also be subjected to increased eddy current and other losses. The temperature rise may also cause unacceptable expansion (and subsequent contraction) of the wires. Also, the insulation of the windings and other components may be adversely affected. Temperatures above designed and desirable levels result in undesirable stresses being applied to the power transformer and or its components. This may cause irreversible damage to the power transformer and its associated components and at a minimum creates stresses causing a range of damages which decrease its life expectancy.

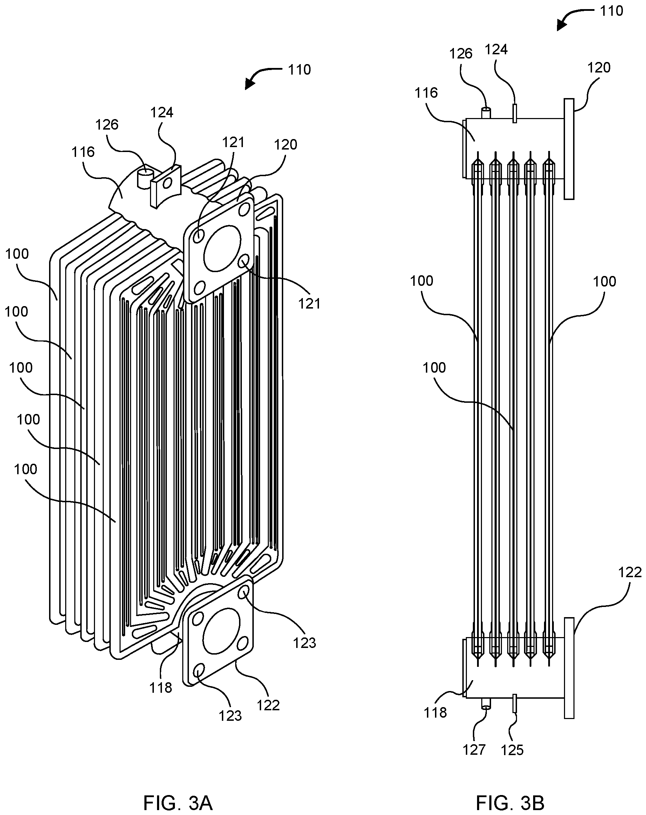

Referring to FIGS. 3A and 3B in combination, as shown, the first collector pipe 116 of the radiator 110 includes a first flange 120 at end thereof to allow for connection with the outflow pipe 112 to receive the fluid at the corresponding radiator 110. Hereinafter, the terms "radiator" and "corrugated radiator" are used interchangeably, without any limitations. For this purpose, the first flange 120 may be provided with apertures

(represented by reference numeral 121). It may be contemplated that the outflow pipe 112 may also have a corresponding flange with apertures (not shown), to mate with the apertures 121 in the first flange 120 of the first collector pipe 116 by using fasteners or the like (not shown). Similarly, the second collector pipe 118 of the radiator 110 includes a second flange 122 at end thereof to allow for connection with the inflow pipe 114 to receive the fluid at the corresponding radiator 110. For this purpose, the second flange 122 may be provided with apertures (represented by reference numeral 123). It may be contemplated that the inflow pipe 114 may also have a corresponding flange with apertures (not shown), to mate with the apertures 123 in the second flange 122 of the second collector pipe 118 by using fasteners or the like (not shown).

Also, as shown in FIGS. 3A and 3B, the radiator 110 may include one or more lugs which may be used to lift the radiator 110. In an example, as shown, one of the lugs 124 may be provided on the first collector pipe 116 and another lug 125 may be provided on the second collector pipe 118. That said, it may be appreciated that one or more of the lugs 124, 125 may be provided on any other location on the radiator 110 suitable for bearing weight of the radiator 110 without any limitations. In an example, the lugs 124, 125 may be designed to couple with a lifting mechanism using a shackle and pin arrangement for the said purpose of lifting the radiator 110, as required. Further, the radiator 110 may include one or more plugs. In an example, as shown, one of the plugs 126 may be provided on the first collector pipe 116 and another plug 127 may be provided on the second collector pipe 118. The plugs 126, 127 are used to allow for releasing air and/or draining oil present in the radiator 110, via the first collector pipe 116 and the second collector pipe 118, such as, in case of need of emptying the radiator 110 for dismantling and/or transportation thereof.

Further, as shown in FIGS. 3A and 3B, the radiator 110 includes one or more heat dissipating elements 100. Herein, the heat dissipating elements 100 are in the form of fins exposed to the atmosphere. The heat dissipating elements 100 are configured to allow the oil to travel inside thereof, causing transfer of heat from the oil to the atmospheric air thereby. In the illustrated embodiments, the radiator 110 is shown to include five heat dissipating elements 100; however, it may be contemplated that the radiator 110 may include more or lesser number of heat dissipating elements 100 depending on the cooling requirement, which in turn may be based on the rating of the transformer device 160 (as shown in FIG. 6) or the like, without departing from the spirit and the scope of the present disclosure. In the present embodiments, the heat dissipating elements 100 are in the form of sheets with certain thicknesses at certain sections thereof (as discussed later in lot more detail). Also, as shown, the heat dissipating elements 100 are arranged parallel to each other in the radiator 110.

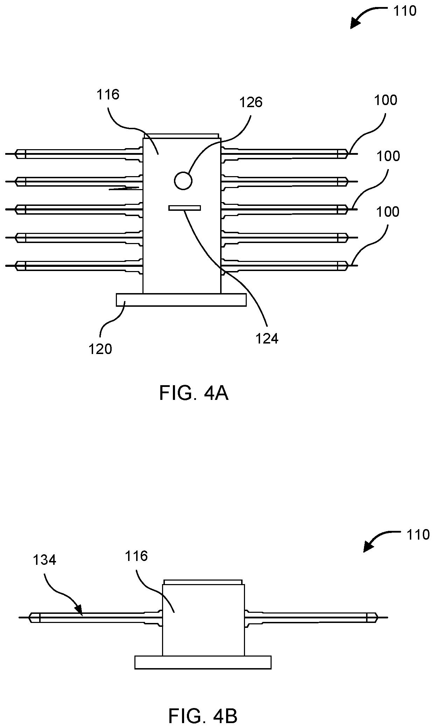

Referring to FIG. 4A, illustrated is a top view of the radiator 110 showing the heat dissipating elements 100 therein. As discussed, in the illustrated embodiments, the radiator 110 is shown to include five (5) number of heat dissipating elements 100. It may be contemplated that the radiator 110 may include from 1 up to 45 number of heat dissipating elements 100 therein, depending on the rating, and thus heating load, of the transformer device 160. FIG. 4B illustrates a top view of the heat dissipating element 100. As shown, the heat dissipating element 100 is connected to the first collector pipe 116 (and similarly to the second collector pipe 118) at the lateral centre thereof. In general, selection of the number of radiators 110 depends on the rating of the transformer device 160. There are different types and rating of the transformer device 160 which requires each of the radiators 110 to include the heat dissipating elements 100 to be as low as just 2 panels and up to 45 panels, and with length of each of the heat dissipating elements 100 starting from 500 mm up to 4500 mm. This is in contrast to traditional designs in which there are many limitations in the selection of number of tubes and length of the tubes for a radiator and its structural integrity as a product. In the present embodiments, the size and the number of heat dissipating elements 100 in the radiator 110 is not particularly limited and depends only on its intended use for the transformer device 160 to be cooled.

FIG. 5A (Prior Art) illustrates a diagrammatic cross-section view of a standard plain flute configuration of a heat dissipation element 500 in a radiator. In the prior art, the heat dissipating element 500 includes flutes 502. As shown in FIG. 5A, a cross-section of each one of the plurality of flutes 502 is in the form of two trapeziums mirrored to each other along bases thereof. FIG. 5B (Prior Art) illustrates a detailed section view of the individual flute 502. It may be seen that the flute 502 has a hexagonal profile, particularly formed of two trapeziums mirrored to each other along bases (as represented by dashed line) thereof.

Referring to FIG. 5A (Prior Art) and FIG. 5B (Prior Art) in combination, as shown, the surface 504 of each mirrored trapezium is flat. In particular, the mirrored trapezium has a flat surface 504 or a plain surface 504. In contrast, referring to FIG. 1A and FIG. 1B in combination, as shown, each mirrored trapezium of the plurality of the flutes 102 incorporates a corrugated profile designed to optimize fluid flow distribution and enhance heat dissipation. This corrugated profile features (of the 9-flute corrugated heat-dissipating element 100) alternating crests and troughs, creating a wave-like pattern along the surface 111 of the mirrored trapeziums. A major axis 106 is defined between the crests, while a minor axis 108 is formed between the troughs. The 9-flute corrugated heat-dissipating element 100 increases thermal efficiency by about 3% compared to the standard plain flute configuration and reduces oil volume by about 10% compared to the standard plain flute configuration shown in FIGS. 5A (Prior Art) and 5B (Prior Art). In the present disclosure, this corrugated profile facilitates improved fluid flow within the flute 102, thereby enhancing the thermal performance of the heat dissipating element 100 and, in turn, the overall radiator 110. The optimized cooling efficiency is achieved through optimal oil channel spacing, resulting from the diverging-converging profiles of the flutes 102, which allow high-viscosity oils, such as ester oil (with a viscosity approximately 3.5 to 5 times greater than mineral oil), to flow smoothly. Thus, even transformer devices with large ratings or capacities, requiring substantial heat dissipation, can be effectively cooled using the radiators 110 of the present disclosure.

Again, referring to FIG. 6, the power transformer 160 is cooled by immersing it in a fluid (e.g., oil, with the two terms being interchangeably used). For this purpose, the housing 162 is filled with the oil to extract heat from the power transformer. Now, this fluid needs to be transferred out of the housing 162 to be cooled and to be re-circulated back into the housing 162 to again be used for heat extraction from the power transformer. The transformer device 160 includes one or more radiators 110. The radiators 110 are heat exchangers used to transfer thermal energy from one medium to another for the purpose of cooling and/or heating, such as, in the present case, from the oil to the atmosphere. The radiators 110 usually provide a large amount of cooling surface to be in contact with large amounts of air so that it spreads through the oil to cool efficiently.

In the illustrated embodiment, the transformer device 160 is shown to include six radiators 110 (four being visible); however, it may be appreciated that the number of radiators 110 implemented for the transformer device 160 may depend on the rating of the power transformer thereof. There are different types and ratings of the transformer device 160 which may warrant as few as one radiator 110 or as many as tens of radiators 110. Further, it may be appreciated that arrangement of the radiators 110 in the illustration of FIG. 6 is exemplary only, and shall not be construed as limiting to the present disclosure. Generally, the radiators 110 may be arranged in the transformer device 160 in any suitable arrangement without departing from the spirit and the scope of the present disclosure.

As may be seen from FIG. 6, the transformer device 160 includes an outflow pipe 112, for each radiator 110, connecting the corresponding radiator 110 and the housing 102, which may allow to transfer the fluid from the inside of the housing 162 to the corresponding radiator 110. It may be contemplated that the transformer device 160 may include one or more pumps (not shown) to provide pumping action for said transfer of the fluid. Further, the transformer device 160 includes an inflow pipe (generally marked by reference numeral 114, not particularly visible in FIG. 6), for each radiator 110, connecting the corresponding radiator 110 and the housing 162, to receive the cooled fluid from the corresponding radiator 110 to be transferred back to the inside of the housing 162. Also, as shown in FIG. 6, each radiator 110 includes the first collector pipe 116 disposed in connection with the housing 162. In particular, the first collector pipe 116 is disposed in connection with the outflow pipe 112 to receive the fluid at the corresponding radiator 110 to be cooled from the inside of the housing 162. Also, each radiator 110 includes a second collector pipe 118 disposed in connection with the housing 162. In particular, the second collector pipe 118 is disposed in connection with the inflow pipe 114 to transfer the cooled fluid from the corresponding radiator 110 to the inside of the housing 162.

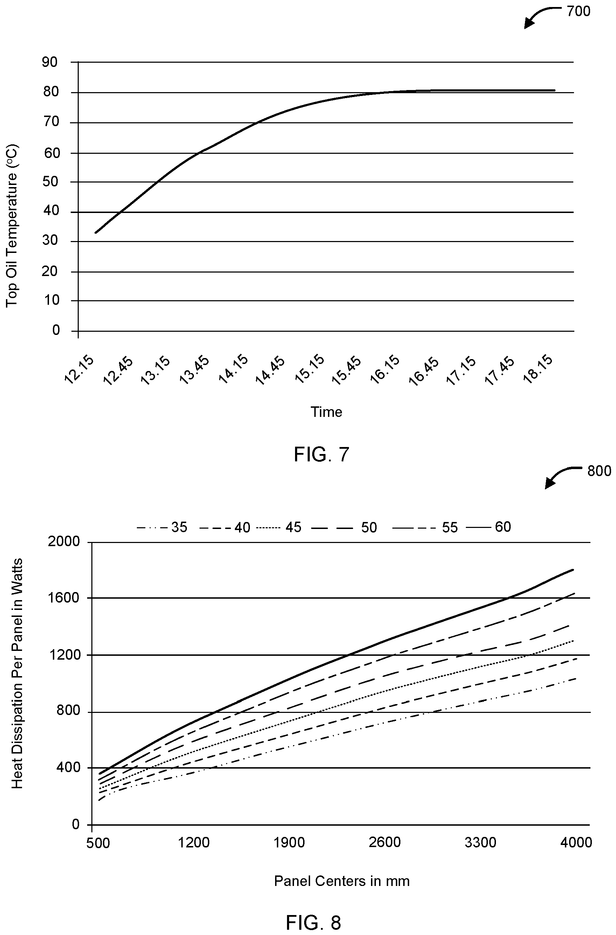

Referring to FIG. 7, illustrated is an exemplary graph 700 indicative of temperature rise of oil with time in the radiator 110, in accordance with one or more exemplary embodiments of the present disclosure. As shown in the graph 700, the top oil temperature in the radiator 110 for ester oil rises faster and stabilizes earlier (as compared to mineral oil in the traditional designs) and the difference between measured top oil and bottom oil temperature for the radiator 110 shows a better temperature drop. This is achieved because of the optimum oil flow in the flutes 102, which helps in reducing the frictional losses, thus speed of flow of fluid remains optimum and thus the heat dissipating elements 100 in the radiator 110 dissipate more heat, which advantageously affects the overall cooling capacity of the radiator 110 for use with the transformer device 160.

Referring to FIG. 8, illustrated is an exemplary graph 800 indicative of rate of heat dissipation from the heat dissipating elements 100 of the radiator 110 across lateral length thereof for different ambient temperature conditions, in accordance with one or more exemplary embodiments of the present disclosure. In testing using thermal imaging apparatus, it was confirmed that the oil was cooled quickly at the outer flutes 102 (i.e., the flutes 102 towards the lateral sides) as compared to the flutes 102 at the lateral centre of the body 132 of the heat dissipating elements 100. As explained in the preceding paragraphs, this is due to more exposure to the ambient air for the outer flutes 102 as compared to the flutes 102 at the lateral centre of the body 132 of the heat dissipating element 100. This is confirmed in the graph 800, as shown, the heat dissipation increases as the distance from the centre of the body 132 of the heat dissipating element 100 increases.

The present disclosure further provides a method of manufacturing a heat dissipating element (such as, the heat dissipating element 100) for a radiator (such as, the radiator 110). It may be appreciated that the teachings as described above, may apply *mutatis mutandis* to the method as described herein below.

At first step, the method includes forming a first metal sheet 113 to define a plurality of first open profiles extending along a longitudinal length thereof. Herein, the first metal sheet 113 may be made of steel. Hereinafter, the term "first open profile" and "first open corrugated profile" are being used interchangeably, without any limitation. Specifically, the first metal sheet 113 may be made of steel material with high formability, such as one of: CRCA IS 513 CR2 grade steel, CRCA IS 513 CR3 grade steel, CRCA IS 513 CR5 grade steel grade steel, and austenitic stainless grade steel. Each of the plurality of first open profiles is in the form of a trapezium opened at base thereof (as shown in reference to FIG. 1B). Further, a wave-like pattern along the surface 111 of the mirrored trapeziums (as shown in reference to FIG. 1B) forms a corrugated profile, wherein the corrugated profile comprises alternating crests and troughs. The plurality of first open corrugated profiles are formed in the first metal sheet 113 using one or more of: rolling operation, stamping operation. In particular, each of the plurality of first open profiles has a diverging section, a straight section, and a converging section. The said diverging section and converging section of the first open profiles may be formed by stamping operation, whereas the straight section may be formed by rolling operation.

At second step, the method includes forming a second metal sheet 115 to define a plurality of second open corrugated profiles extending along a longitudinal length thereof. Herein, the second metal sheet 115 may be made of steel. Hereinafter, the term "second open profile" and "second open corrugated profile" are being used interchangeably, without any limitation. Specifically, the second metal sheet 115 may be made of steel material with high formability, such as one of: CRCA IS 513 CR2 grade steel, CRCA IS 513 CR3 grade steel, CRCA IS 513 CR5 grade steel grade steel, and austenitic stainless grade steel (similar to the first metal sheet 113). Each of the plurality of second open profiles is in the form of a trapezium opened at base thereof (as shown in reference to FIG. 1B). Further, a wave-like pattern along the surface 111 of the mirrored trapeziums (as shown in reference to FIG. 1B) forms a corrugated profile, wherein the corrugated profile comprises alternating crests and troughs. The plurality of second open corrugated profiles are formed in the second metal sheet 115 using one or more of: rolling operation, stamping operation. In particular, each of the plurality of second open profiles has a diverging section, a straight section, and a converging section (complementary to the defined sections in the first metal sheet 113). The said diverging section and converging section of the second open profiles may be formed by stamping operation, whereas the straight section may be formed by rolling operation.

At third step, the method includes joining the first metal sheet 113 and the second metal sheet 115 so as to form a body (such as, the body 132) having a top portion (such as, the top portion 134), a bottom portion (such as, the bottom portion 136) and a middle portion (such as, the middle portion 138), and a plurality of flutes (such as, the plurality of flutes 102) with a corrugated profile defined therein from the plurality of first open profiles and the plurality of second open profiles closing each other, with each of the plurality of flutes 102 with the corrugated profile providing a continuous channel to allow for flow of a fluid therein. It may be appreciated that because of the complementary defined diverging sections, the straight sections and the converging sections in the first metal sheet 113 and the second metal sheet 115, when the two sheets 113, 115 are joined, the plurality of flutes 102 are formed with the diverging-converging profiles. Further, because of each of the plurality of first open profiles and each of the plurality of second open profiles being in form of a trapezium opened at base thereof, a cross-section of each one of the plurality of flutes 102 is in the form of two trapeziums mirrored to each other along the bases thereof. In the present embodiments, the two sheets may be joined by multi-spot resistance welding technique, as may be performed by automated robots or the like. Further, in some examples, neck trimming technology may be implemented to eliminate non- uniform welding of the two sheets by using loop welding methodology.

At fourth step, the method includes providing an inlet port (such as, the inlet port 140) at the top portion 134 of the body 132 to receive the fluid and supply the fluid to each of the plurality of flutes 102. The said inlet port 140 is disposed in fluid communication with the first collector pipe 116 to receive the fluid therefrom, and to supply the fluid to each of the plurality of flutes 102. At fifth step, the method includes providing an outlet port (such as, the outlet port 142) at the bottom portion 136 of the body 132 to collect the fluid from each of the plurality of flutes 102. The said outlet port 142 is disposed in fluid communication with the second collector pipe 118 to supply the collected fluid thereto. Herein, the first collector pipe 116 and the second collector pipe 118 may be made of mild steel, and the heat dissipating element(s) 100 may be welded therewith for forming such connections. The present disclosure provides optimum hydraulic dimensions for the oil channels provided by the flutes 100, increasing the thermosyphon effect of cooling (i.e., Oil Natural Air Natural (ONAN) cooling) because of less frictional resistance compared to traditional designs. The present disclosure further solves the problem of the transformer industry switching to ester-based oils (because of their bio-degradability) by allowing use of high-viscosity fluids in the radiator 110.

Thus, the method of the present disclosure provides the radiator 110 with the heat dissipating elements 100 in which one or more of the plurality of flutes 102 are extending longitudinally downwards and diverging laterally outwards from the inlet port 140 in the top portion 134 of the body 132, extending longitudinally downwards in the middle portion 138 of the body 132, and extending longitudinally downwards and converging laterally inwards towards the outlet port 142 in the bottom portion 136 of the body 132. This design of the radiators 110 is unique with stamped plate, and with a divergent and convergent pattern for diverting the oils away from the first collector pipe 116. This helps the oil from the first collector pipe 116 to travel away from the lateral centre of the body 132, helping the oil at the end flutes 102 to cool quickly before being supplied to the second collector pipe 118 to be used for cooling of the transformer device 160, creating a thermographic profile of parabolic in shape. In some examples, the radiator 110 as formed may be galvanized by hot dip technique to increase the life thereof. In some examples, the radiator 110 as formed is coated with duplex coating system (HDG + Paint) to provide better edge protection, excellent corrosion resistance, to serve for long periods with minimum maintenance at site.

In traditional designs of the radiators, for high viscous oil if the hydraulic dimension of the channels is small, the frictional forces are more. If the hydraulic dimension is large, the manufacturing of the radiator may be limited by process limitations and the transformers will endure from excess oil consumption. This becomes a major setback in the thermal performance of the radiator. The present disclosure provides the radiator(s) 110 with the heat dissipating elements 100 with optimized channels in the form of corrugated flutes 102 having shape as diverging from the inlet port 140 from the top portion 134 with the first collector pipe 116 to the middle portion 138, and converging from the middle portion 138 to the outlet port 142 at the bottom portion 136 leading to the second collector pipe 118. Such diverging-converging profile helps with the oil to be distributed evenly through all the flutes 102, and also enhances better heat dissipation through the heat dissipating elements 100 due to the corrugated profile of the flutes 102. Further, the 9-flute corrugated heat dissipating element 100 design enhances thermal efficiency by about 3% compared to the standard plain flute configuration and reduces oil volume by about 10% compared to the standard plain flute configuration. In particular, the diverging-converging profile helps in faster temperature drop from the lateral sides (edges) of the heat dissipating elements 100, showing a parabolic curve in temperature profile. The present disclosure allows the heat dissipating elements 100 to accommodate larger collector pipes 116, 118 and additional flutes 102 to carry excess oil because of higher thermal performance, thus increasing the overall cooling effect provided by the radiator(s) 110 for the transformer device 160.

In the present disclosure, the radiator is designed to operate effectively in both natural convection (thermosiphon effect) and forced convection cooling modes. In natural convection, the tapered corrugated design encourages smooth, uninterrupted oil flow, while in forced convection, it ensures higher flow efficiency, further enhancing thermal performance.

The 9-flute corrugated design offers approximately 3% better thermal performance than the standard plain flute radiator. This improvement ensures that transformers filled with high viscous ester-based oils can operate at optimal temperatures without overheating, thereby enhancing reliability and longevity.

The corrugated design reduces the oil volume required by around 10% compared to the standard plain flute radiator. This reduction in oil consumption translates directly to cost savings for customers, who require less oil without compromising on cooling efficiency.

The design is specifically tailored for use with high viscous dielectric oils, such as ester-based oils, which have a higher viscosity than traditional mineral oils. This makes the radiator highly suitable for modern transformer applications that prioritize environmentally friendly and safer dielectric fluids.

The foregoing descriptions of specific embodiments of the present disclosure have been presented for purposes of illustration and description. They are not intended to be exhaustive or to limit the present disclosure to the precise forms disclosed, and obviously many modifications and variations are possible in light of the above teaching. The exemplary embodiment was chosen and described in order to best explain the principles of the present disclosure and its practical application, to thereby enable others skilled in the art to best utilize the present disclosure and various embodiments with various modifications as are suited to the particular use contemplated.

## Claims

1. A corrugated heat dissipating element for a radiator, the heat dissipating element comprising:
a body having a top portion, a bottom portion and a middle portion;
a plurality of flutes defined in the body, with each of the plurality of flutes providing a continuous channel to allow for flow of a fluid therein;
an inlet port provided at the top portion to receive the fluid and supply the fluid to each of the plurality of flutes; and
an outlet port provided at the bottom portion to collect the fluid from each of the plurality of flutes,
wherein one or more of the plurality of flutes are extending longitudinally downwards and diverging laterally outwards from the inlet port in the top portion of the body, extending longitudinally downwards in the middle portion of the body, and extending longitudinally downwards and converging laterally inwards towards the outlet port in the bottom portion of the body,
wherein a cross-section of each one of the flutes has a hexagonal profile, formed of two trapeziums mirrored to each other along bases thereof, and
wherein each of the mirrored trapeziums of the plurality of flutes includes a corrugated profile to optimize fluid flow distribution and enhance heat dissipation, and wherein the corrugated profile comprises alternating crests and troughs, forming a wave-like pattern along the surface of the mirrored trapeziums, such that a maj or axis is formed between the crests of the mirrored trapeziums and a minor axis is formed between the troughs of the mirrored trapeziums.

2. The heat dissipating element as claimed in claim 1, wherein the plurality of flutes comprises nine number of flutes.

3. The heat dissipating element as claimed in claim 1, wherein a sheet surface of the body comprising the plurality of flutes is configured in a trapezoidal shape.

4. The heat dissipating element as claimed in claim 1, wherein the fluid comprises high viscous dielectric oil including ester oil.

5. The heat dissipating element as claimed in claim 1, wherein a longitudinal length of each of the one or more heat dissipating elements is in a range of 500 mm up to 4500 mm.

6. The heat dissipating element as claimed in claim 1, wherein the heat dissipating element comprises:
a first metal sheet formed to define a plurality of first open corrugated profiles extending along a longitudinal length thereof; and
a second metal sheet formed to define a plurality of second open corrugated profiles extending along a longitudinal length thereof, the second corrugated profiles being complementary to the plurality of predefined open corrugated profiles formed in the first metal sheet,
wherein the first metal sheet and the second metal sheet are joined so as to form the body having the top portion, the bottom portion and the middle portion, with the plurality of flutes defined therein by the closed configuration of the first open corrugated profiles and the second open corrugated profiles,
wherein each of the plurality of flutes forming an optimized continuous channel configured to allow fluid flow therethrough, thereby reducing oil consumption and enhancing heat dissipation.

7. A radiator for cooling a device, the device having a fluid flowing therethrough to extract heat therefrom, the radiator comprising:
a first collector pipe disposed in connection with the device to be cooled to receive the fluid therefrom;
a second collector pipe disposed in connection with the device to be cooled to supply back the fluid thereto; and
one or more corrugated heat dissipating elements, wherein each of the one or more corrugated heat dissipating elements comprises:
a body having a top portion, a bottom portion and a middle portion;
a plurality of flutes defined in the body, with each of the plurality of flutes providing a continuous channel to allow for flow of the fluid therein;
an inlet port provided at the top portion in fluid communication with the first collector pipe to receive the fluid therefrom, and to supply the fluid to each of the plurality of flutes; and
an outlet port provided at the bottom portion to collect the fluid from each of the plurality of flutes, and in fluid communication with the second collector pipe to supply the collected fluid thereto,
wherein one or more of the plurality of flutes are extending longitudinally downwards and diverging laterally outwards from the inlet port in the top portion of the body, extending longitudinally downwards in the middle portion of the body, and extending longitudinally downwards and converging laterally inwards towards the outlet port in the bottom portion of the body,
wherein a cross-section of each one of the flutes has a hexagonal profile, formed of two trapeziums mirrored to each other along bases thereof, and
wherein each of the mirrored trapeziums of the plurality of flutes includes a corrugated profile to optimize fluid flow distribution and enhance heat dissipation, the corrugated profile comprises alternating crests and troughs, forming a wave-like pattern along the surface of the mirrored trapeziums, such that a major axis is formed between the crests of the mirrored trapeziums and a minor axis is formed between the troughs of the mirrored trapeziums.

8. The radiator as claimed in claim 6, wherein a longitudinal length of each of the one or more heat dissipating elements is in a range of 500 mm up to 4500 mm.

9. The radiator as claimed in claim 6, wherein a number of the one or more heat dissipating elements varies from 1 to 45.

10. The radiator as claimed in claim 6, wherein a sheet surface of the body comprising the plurality of flutes is configured in a trapezoidal shape.

11. The radiator as claimed in claim 6, wherein the fluid comprises high viscous dielectric oil including ester oil.
